# EUROPEAN PATENT APPLICATION

(11) **EP 4 664 531 A1**
(43) Date of publication of application: **17.12.2025**
(21) Application number: 24305921.9
(22) Date of filing: 11.06.2024
(51) Int. Cl.: H01L 29/94

(54) **ELECTRICAL DEVICE COMPRISING A CAPACITOR WITH A DIELECTRIC STRUCTURE PREVENTING DELIMINATION**

(71) Applicant: Murata Manufacturing Co., Ltd., Nagaokakyo-shi, Kyoto 617-8555 (JP)
(72) Inventor: GABORIEAU, Sophie, 14210 Sainte-Honorine-du-Fay (FR); BOUVIER, Stéphane, 14610 CAIRON (FR)
(74) Representative: Cabinet Beau de Loménie

(57) **Abstract**

The present invention relates to an electrical device and a method for manufacturing thereof. In particular, the proposed electrical device (100) comprises a capacitor including:
- a bottom electrode structure (110) comprising a silicon substrate (112), the silicon substrate (112) comprising:
∘ a region (112-D) doped with phosphorus and extending up to all lateral edges of the electrical device (100),

- a dielectric structure (120) extending on the bottom electrode structure (110), the dielectric structure (120) comprising at least:
∘ a dielectric layer (121) comprising thermal silicon dioxide on the silicon substrate (112), a thickness of this layer (121) being equal to or greater than 20 nm,

- a top electrode structure (130) extending on the dielectric structure (120).

## Description

### Field of the invention

The present invention relates to the field of electrical devices. More particularly, it relates to an electrical device comprising a capacitor and a method for manufacturing thereof.

### Description of Related Art

The present invention lies within the context of electrical devices comprising capacitors formed using a semiconductor substrate on which extends a dielectric structure. For instance, the present invention applies to vertical capacitors, wherein the bottom electrode is formed by a highly doped silicon substrate and a backside metallization (*i.e*., a conductive layer formed on the bottom surface of the substrate). In this context, the semiconductor substrate is doped to achieve the desired electrical properties. In particular, it can be advantageous to dope the semiconductor substrate with phosphorus in view of improving the capacitor characteristics.

The semiconductor wafer cannot be doped with phosphorus over its entire surface (*i.e*., using full-sheet doping) using techniques in accordance with the prior art to manufacture such capacitors. While this would minimize the number of manufacturing steps and would greatly simplify the manufacturing process (since no patterning steps or masks are required), it has been observed that full-sheet doping leads to defects for conventional capacitor structures.

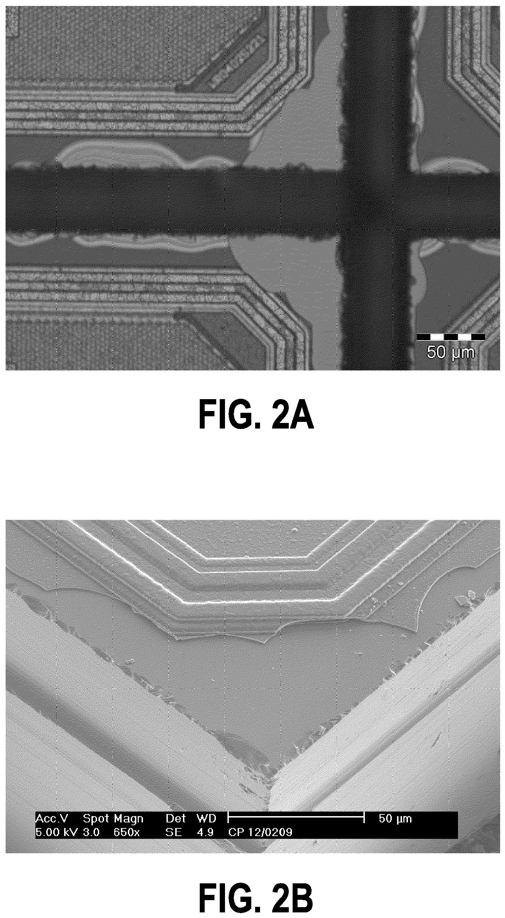

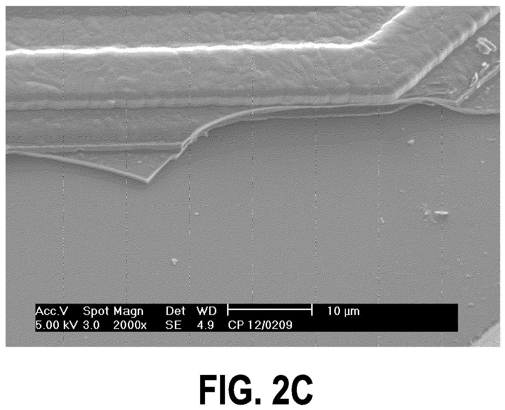

When the wafer is doped with phosphorus over its entire surface, including the saw lanes, the inventors have observed that delamination of conventional capacitor structures occurs when dicing the wafer (*i.e*., mechanical sawing of the wafer through said saw lanes). If delamination reaches the seal ring of the electrical device, the latter has to be rejected. In such a case of delamination, humidity can penetrate into the device, affecting its operation and deteriorating its reliability. For illustration purposes, FIGS. 2A-2C illustrate electrical devices wherein delamination has reached the seal ring.

Therefore, there is a need for a solution that allows a semiconductor wafer to be doped with phosphorus over its entire surface and prevents delamination of a dielectric structure formed on the wafer when dicing it.

### Summary of the invention

The present invention has been made in light of the above problems.

According to an aspect, the present invention provides an electrical device comprising a capacitor including:
- a bottom electrode structure comprising a silicon (Si) substrate, the silicon substrate comprising:
   ∘ a region doped with phosphorus (P) and extending up to all of the lateral edges of the electrical device,
- a dielectric structure extending on (*i.e*., in contact with) the bottom electrode structure, the dielectric structure comprising at least:
   ∘ a dielectric layer (referred to as the *first dielectric layer)* comprising thermal silicon dioxide (SiO₂) on (*i.e*., in contact with) the silicon substrate, a thickness of this layer being equal to or greater than 20 nm,
- a top electrode structure extending on (*i.e*., in contact with) the dielectric structure.

The present invention proposes doping the entire surface of the wafer with phosphorus (including the saw lanes), and then selecting a particular dielectric structure (formed on the wafer) to prevent delamination when dicing the wafer.

On the one hand, the present invention proposes doping the entire surface of a silicon wafer with phosphorus (*i.e*., full-sheet doping). This is why the region of the silicon substrate doped with phosphorus extends up to all lateral edges of the proposed electrical device. The use of full-sheet doping allows minimizing the number of manufacturing steps required to obtain the proposed electrical device. The latter can therefore be easily obtained using conventional manufacturing techniques.

It should also be mentioned that doping the silicon wafer with phosphorus improves the electrical properties of the proposed electrical device. Specifically, doping the silicon substrate with phosphorus allows obtaining a highly conductive bottom electrode structure. This improves capacitance linearity with voltage.

On the other hand, the present invention proposes selecting a particular dielectric structure to prevent delamination when dicing the wafer (since the substrate is doped with phosphorus over its entire surface including the saw lanes). More specifically, the materials and thicknesses of the layers of the dielectric structure are selected to improve adherence to the substrate, and thereby prevent delamination.

The inventors' experimental results have shown that the materials and thicknesses of the layers of the dielectric structure have a significant impact on the occurrence and severity of delamination. These results have, in particular, shown that a thick layer (*i.e*., equal to or greater than 20 nm) of thermal silicon dioxide achieves a strong adherence to the silicon substrate, and prevents delamination when dicing the wafer.

For these reasons, the present invention provides an electrical device that can be manufactured by doping the entire surface of a wafer with phosphorus while avoiding delamination of the dielectric structure when dicing the wafer.

The present invention applies, *inter alia,* to vertical capacitors. In other words, in a particular embodiment, the bottom electrode structure comprises: the (highly) doped silicon substrate, and a conductive layer formed on the bottom surface of the substrate (this conductive layer is hereinafter referred to as the backside metallization).

In a particular embodiment, the dielectric structure comprises a stack of layers including:
- the dielectric layer (the first dielectric layer) comprising thermal silicon dioxide (SiO₂), the thickness of this layer being comprised between 65 and 75 nm, and
- a dielectric layer (referred to as the *second dielectric layer)* comprising silicon oxynitride (*i.e*., Si₃N₄ with a surface oxidation), a thickness of this layer being comprised between 50.5 and 60.5 nm.

This particular arrangement has been observed by the inventors to minimize delamination during dicing.

In a particular embodiment, the dielectric structure comprises a stack of layers including:
- the dielectric layer (the first dielectric layer) comprising thermal silicon dioxide, the thickness of this layer being comprised between 20 and 30 nm,
- a dielectric layer (the second dielectric layer) comprising silicon nitride (Si₃N₄), a thickness of this layer being comprised between 46.5 and 56.5 nm, and
- another dielectric layer (referred to as the *third dielectric layer)* comprising silicon dioxide (SiO₂), a thickness of this layer being comprised between 10 and 20 nm.

This particular arrangement has been observed by the inventors to minimize delamination during dicing.

In a particular embodiment, the dielectric structure comprises a stack of layers including:
- the dielectric layer (the first dielectric layer) comprising thermal silicon dioxide (SiO₂), the thickness of this layer being comprised between 95 and 105 nm,
- a dielectric layer (the second dielectric layer) comprising silicon nitride (Si₃N₄), a thickness of this layer being comprised between 95 and 105 nm, and
- another dielectric layer (the third dielectric layer) comprising silicon dioxide (SiO₂), a thickness of this layer being comprised between 10 and 20 nm.

This particular arrangement has been observed by the inventors to minimize delamination during dicing.

The inventors have observed, through multiple experiments, that these different configurations of the dielectric structure are particularly advantageous. The inventors' experimental results show that these configurations provide a dielectric structure with a high dielectric strength and that prevents delamination when dicing the wafer. Specifically, the use of silicon nitride allows providing a dielectric structure with a high dielectric strength, and (as previously mentioned) the use of thermal silicon dioxide provides a dielectric structure with a strong adherence to the silicon substrate

The dielectric structure of the proposed electrical device may, according to particular embodiments, comprise only the above-mentioned dielectric layers. However, the present invention is not limited to these particular embodiments. Within the scope of the invention, other embodiments can also be envisaged in which the dielectric structure comprises additional layers beyond those mentioned.

In a particular embodiment, the substrate is a silicon substrate doped with boron (B) *(i.e.,* P+ doping) or with arsenic (As) (*i.e*., N+ doping), comprising the region doped with phosphorus.

The inventors' experimental results have shown that these two types of substrate (doped with boron or arsenic) yield the same delamination results. Provided that the dielectric structure is selected appropriately (as described above), delamination of the capacitor structure can be avoided when dicing the wafer, for both types of substrate.

In a particular embodiment, the electrical device comprises no further dielectric layer extending on or above the top electrode structure, at least (in a region) along the lateral edges of the electrical device (*i.e*., at least in the saw lanes).

The inventors' experimental results have shown that the presence of an insulating layer extending on the top electrode structure can result in delamination when dicing the wafer. This embodiment therefore proposes that the electrical device does not include other dielectric layers (*e.g*., no inter-metal oxide layer) extending on or above the top electrode structure in the saw lanes. This embodiment contributes to further preventing delamination when dicing the wafer.

More specifically, the electrical device can further include a conductive layer extending on the top electrode structure, for instance, to form electrical contacts and/or connections. It could then be envisaged to include an inter-metal oxide layer extending between the top electrode structure and the conductive layer forming the electrical contacts. However, the inventors' experimental results have shown that the presence of such an inter-metal oxide layer in the saw lane can result in delamination. Therefore, this embodiment proposes that the electrical device includes no inter-metal oxide layer in the saw lanes to prevent delamination when dicing the wafer.

In a particular embodiment, the silicon substrate comprises reliefs (*e.g*., trenches, columns, holes, or pillars), the dielectric structure extends conformally on the reliefs of the silicon substrate, and the top electrode structure extends conformally on the dielectric structure.

This embodiment proposes using a three-dimensional (3D) capacitor using a substrate with reliefs such as trenches, holes, columns, or pillars. This allows increasing the specific area of the capacitor for a given component size. This embodiment thereby provides an electrical device with a high capacitance density.

In addition, the use of a silicon substrate allows using thick dielectric layers (*e.g*., by using wide trenches). This would provide a capacitor with a high breakdown voltage.

It should be noted that the present invention is not limited to 3D capacitors, and also applies to planar capacitors.

According to another aspect, the present invention provides a method for manufacturing an electrical device comprising a capacitor, said method comprising:
- providing a bottom electrode structure comprising a silicon substrate, the silicon substrate having a (top) surface and comprising:
   ∘ a region doped with phosphorus and extending over substantially all of the (top) surface of the silicon substrate (*i.e*., full-sheet doping is used, the doping is performed without any patterning masks),
- forming a dielectric structure extending on the bottom electrode structure, this step comprising:
   ∘ forming a dielectric layer comprising silicon dioxide by thermal oxidation of the silicon substrate, a thickness of this layer being equal to or greater than 20 nm,
- forming a top electrode structure extending on the dielectric structure.

The proposed manufacturing method can be adapted to obtain any one of the electrical devices defined in the present disclosure.

The embodiments of the proposed method for manufacturing an electrical device present the advantages described in relation with the embodiments of the proposed electrical device.

In a particular embodiment, the step of providing the bottom electrode structure comprises:
- full-sheet doping of the silicon substrate with phosphorus.

In a particular embodiment, the proposed manufacturing method comprises:
- dicing to delimit the electrical device, wherein the dicing is performed through the region doped with phosphorus (*i.e*., the silicon substrate is doped with phosphorus in the saw lanes).

In a particular embodiment, the thickness of the dielectric layer (the first dielectric layer) comprising thermal silicon dioxide is comprised between 65 and 75 nm.

Furthermore, in this embodiment, the step of forming the dielectric structure further comprises:
- forming a dielectric layer (the second dielectric layer) comprising silicon nitride and oxidizing this layer, a thickness of this layer being comprised between 50.5 and 60.5 nm.

In a particular embodiment, the thickness of the dielectric layer (the first dielectric layer) comprising thermal silicon dioxide is comprised between 20 and 30 nm.

Furthermore, in this embodiment, the step of forming the dielectric structure further comprises:
- forming a dielectric layer (the second dielectric layer) comprising silicon nitride, a thickness of this layer being comprised between 46.5 and 56.5 nm, and
- forming another dielectric layer (the third dielectric layer) comprising silicon dioxide, a thickness of this layer being comprised between 10 and 20 nm.

In a particular embodiment, the thickness of the dielectric layer (the first dielectric layer) comprising thermal silicon dioxide is comprised between 95 and 105 nm.

Furthermore, in this embodiment, the step of forming the dielectric structure further comprises:
- forming a dielectric layer (the second dielectric layer) comprising silicon nitride, a thickness of this layer being comprised between 95 and 105 nm, and
- forming another dielectric layer (the third dielectric layer) comprising silicon dioxide, a thickness of this layer being comprised between 10 and 20 nm.

The dielectric layer comprising thermal silicon dioxide (the first dielectric layer) is formed by thermal oxidation of the silicon substrate. The dielectric layer comprising silicon nitride (the second dielectric layer) can be formed using low pressure chemical vapor deposition. And, the other dielectric layer comprising silicon dioxide (the third dielectric layer) can be formed using chemical vapor deposition of tetraethylorthosilicate.

### Brief Description of the Drawings

Further features and advantages of the present invention will become apparent from the following description of certain embodiments thereof, given by way of illustration only, not limitation, with reference to the accompanying drawings in which:
FIG. 1 illustrates a cross-section view of an electrical device according to an embodiment of the present invention;
FIGS. 2A-2C illustrate electrical devices wherein delamination of the dielectric structure has occurred;
FIGS. 3A and 3B illustrate electrical devices wherein different extents of delamination have occurred; and
FIG. 4 illustrates a cross-section view of an electrical device according to another embodiment.

### Detailed Description of Example Embodiments

The present invention provides an electrical device comprising a capacitor with a dielectric structure preventing delamination. More specifically, embodiments of the present invention seek to provide a solution that allows a semiconductor wafer to be doped with phosphorus over its entire surface and prevents delamination of a dielectric structure formed on the wafer when dicing it.

The present invention lies, in particular, within the context of 3D capacitors formed using semiconductor substrates. The following description of the invention will refer to this particular context, which is only given as an illustrative example and should not limit the invention. The invention can also be used for planar capacitors.

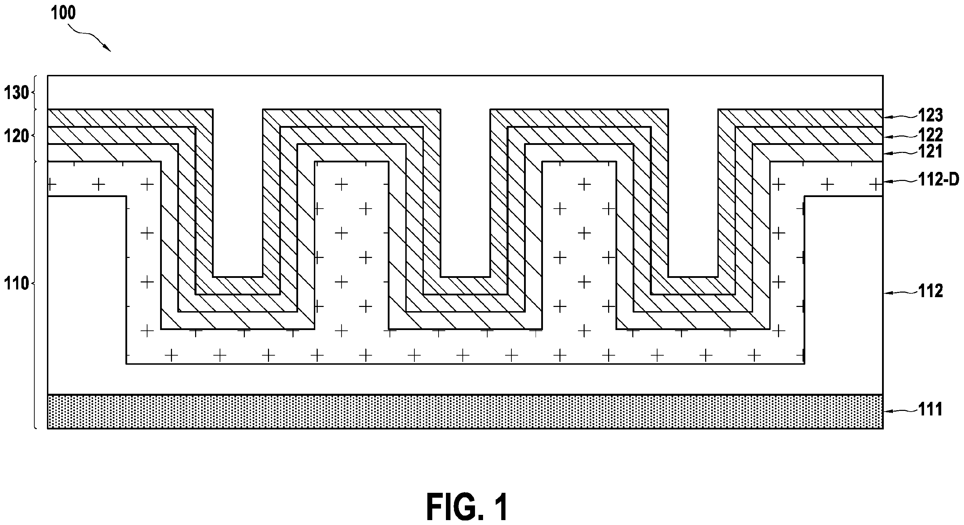

**FIG. 1** illustrates a cross-section view of an electrical device according to an embodiment of the present invention. This figure is described hereinafter to introduce the present invention.

In the embodiment of FIG. 1, the electrical device 100 comprises a capacitor formed by: a bottom electrode structure 110, a top electrode structure 130, and a dielectric structure 120 interposed between the bottom electrode structure 110 and the top electrode structure 130.

The bottom electrode structure 110 comprises here: a backside metallization 111, and a silicon substrate 112.

The backside metallization 111 is provided by a conductive layer formed on the bottom surface of the substrate 112 (*i.e*., the opposite surface on which is deposited the dielectric structure 120).

The silicon substrate 112 comprises a region 112-D doped with phosphorus. It is important to note that the region 112-D extends up to all lateral the edges of the electrical device 100 (only two being visible on the figure). This results from the fact that the silicon wafer is doped with phosphorus over its entire top surface, including the saw lanes. In other words, full-sheet doping is used to dope the substrate 112.

More precisely, considering a side view of substrate 112, the doped region 112-D extends from the top surface of substrate 112 to a certain depth (as shown on FIG. 1). Considering a top view of substrate 112, the doped region 112-D extends over (substantially) all of the top surface of the substrate 112 and up to all the edges of this surface.

Doping the silicon substrate 112 with phosphorus significantly improves the capacitor characteristics including its capacitance linearity with voltage. Moreover, doping the entire surface of the wafer with phosphorus (*i.e*., full-sheet doping) allows minimizing the number of manufacturing steps required to obtain the proposed electrical device 100.

In the embodiment of FIG. 1, the substrate 112 comprises reliefs (also called contours). For instance, it can comprise trenches, or holes. The capacitor of the electrical device 100 is therefore a 3D capacitor. This allows increasing the specific area of the capacitor for a given component size, and achieving a high capacitance density.

In particular, a substrate comprising reliefs presents a surface (here its top surface) having portions that extend horizontally and vertically, *i.e.* that extend along three orthogonal directions.

The dielectric structure 120 extends conformally over the bottom electrode structure 110, and comprises a stack of multiple dielectric layers 121-123 (stacked on each other in the bottom electrode 110 to top electrode 130 direction).

The dielectric structure 120 comprises at least a first dielectric layer 121 comprising thermal silicon dioxide extending on *(i.e.,* in contact with) the silicon substrate 112. The dielectric structure 120 can further comprise one or more additional dielectric layers 122-123.

The materials and thicknesses of the various layers 121-123 of the dielectric structure 120 represent important aspects of the present invention, and will be detailed below in reference to the inventors' experimental results.

The top electrode structure 130 comprises a conductive layer (*e.g.*, a layer of polysilicon) extending conformally over the dielectric structure 120.

As illustrated on FIG. 1, the top electrode structure 130 fills the above-mentioned reliefs (*e.g*., trenches, or holes) formed by the bottom electrode structure 110 and the dielectric structure 120. That is, the top surface of the top electrode structure 130 lies above the top surface of the dielectric structure 120.

The capacitor of the embodiment of FIG. 1 is referred to as a vertical capacitor. That is, the capacitor is formed by the bottom electrode 110 comprising the (highly) doped silicon substrate 112 and the backside metallization 111, on which extend the dielectric structure 120 and the top electrode 130.

We previously mentioned that doping the entire surface (full sheet doping) of the silicon wafer with phosphorus is particularly advantageous. This improves the electrical characteristics of the electrical device, while ensuring a simple manufacturing process. However, this can lead to delamination when dicing the wafer. Such a delamination is illustrated by the following figures.

**FIGS. 2A-2C** illustrate electrical devices wherein delamination of the dielectric structure has occurred. These figures are described to introduce the problem of delamination when dicing the wafer.

When the silicon substrate 112 is doped with phosphorus over its entire top surface, and including in the saw lanes, the inventors have observed that delamination occur when dicing the wafer. As illustrated on FIGS. 2A-2C, the delamination can reach the seal ring of the electrical device 100 (*i.e*., a ring that surrounds the functional part of the device to protect it from eventual cracks). In such a case of delamination, humidity can penetrate the electronic device 100 and affect its proper operation. This can lead to the rejection of the electronic device 100.

More specifically, the inventors have observed that delamination occurs predominantly at the interface between the silicon substrate 112 and the dielectric structure 120. There is no chipping of the silicon substrate 112, only delamination of the dielectric layers 121-123 in the saw lanes. The causes of this delamination are the following.

Doping the silicon substrate 112 with phosphorus has a significant impact on the interface between the silicon substrate 112 and the dielectric structure 120 (and, more specifically, on the adherence between the two layers of this interface). Phosphorus diffuses into the thermal silicon dioxide layer 121, and weakens the interface between the silicon substrate 112 and the dielectric structure 120.

Phosphorus doping also induces mechanical stress within the structure. One of the most important factors influencing the adherence of a deposited layer to a substrate is the residual stress. Whenever an external stress is applied on the interface between the deposited layer and the substrate (*e.g*., a stress caused by the mechanical sawing of the wafer), this external stress adds up to the residual stress. This also contributes delamination.

Therefore, the doping of the silicon substrate 112 and the configuration of the dielectric structure 120 in the saw lanes have been observed to have a substantial impact on the occurrence and severity of delamination when dicing the wafer.

This raises the question of how to select the materials and thickness of the layers of dielectric structure 120 to improve its adherence to the silicon substrate 112, and thus prevent delamination. To answer this question, the inventors have carried out multiple experiments and have obtained the following results (Tables 1-3 below) that support the present invention.

**Table 1: Influence of the thickness of the dielectric structure 120 on delamination**

| Si substrate | capacitor dielectric structure 120 | | blade dicing results |
|---|---|---|---|
| | SiO₂ layer 121 (Thermal) | Si₃N₄ layer 122 (LPCVD) | |
| N+ As doped | 2 nm | 55.5 nm + oxidation | NOK: |
| | | | Strong Delamination |
| 1-5 mohm.cm | 70 nm | 55.5 nm + oxidation | ~OK: Acceptable delamination |
| P+ B doped | 2 nm | 55.5 nm + oxidation | NOK: |
| | | | Strong Delamination |
| 25-38 mohm.cm | 70 nm | 55.5 nm + oxidation | ~OK: |
| | | | Acceptable delamination |

Table 1 outlines the experimental results obtained for different configurations of the dielectric structure 120.

In these configurations, the dielectric structure 120 comprises a stack of a first dielectric layer 121 and a second dielectric layer 122. The first dielectric layer 121 extends on (*i.e*., in contact with) the bottom electrode structure 112. It comprises thermal silicon dioxide SiO₂. This means that the first dielectric layer 121 is formed by thermal oxidation of the silicon substrate 112.

The second dielectric layer 122 extends on (*i.e*., in contact with) the first dielectric layer 121. It comprises silicon oxynitride (*i.e*., Si₃N₄ with a surface oxidation). This layer 122 is obtained by depositing silicon nitride using LPCVD (Low Pressure Chemical Vapor Deposition), and then by performing a surface oxidation of the silicon nitride.

More specifically, Table 1 outlines the blade dicing results (*i.e*., delamination results) obtained for different thicknesses of the thermal silicon dioxide layer 121 of the dielectric structure 120.

The rows in which the dicing results are indicated as NOK mean that the severity of delamination was not acceptable. Conversely, the rows in which the dicing results are indicated as *OK* mean that there was no delamination, or that it was sufficiently minor to be acceptable.

With regard to these experimental results, it should first be noted that they confirm that the materials and thickness of the dielectric structure 120 has a significant impact on the occurrence of delamination when dicing the wafer. The same delamination results have been obtained for the two types of silicon substrates 112: a silicon substrate doped with boron (P+ doping), and a silicon substrate doped with arsenic (N+ doping). In particular, the silicon substrate 112 can be highly doped with boron or arsenic.

In particular, Table 1 shows that the thickness of the thermal silicon dioxide layer 121 has a major impact on delamination. To avoid dielectric layers present in the saw lanes to delaminate when dicing the wafer, the thermal silicon dioxide layer 121 has to be sufficiently thick. Specifically, the thickness of the thermal silicon dioxide layer 121 must be equal to or greater than 20 nm (see Tables 2 and 3 below).

This condition on the thickness of the dielectric layer 121 must be verified at least at the level of the saw lanes (*i.e*., over substantially all of the periphery of the electronic device 100, once the wafer has been diced), but can also be verified over substantially all of this dielectric layer 121.

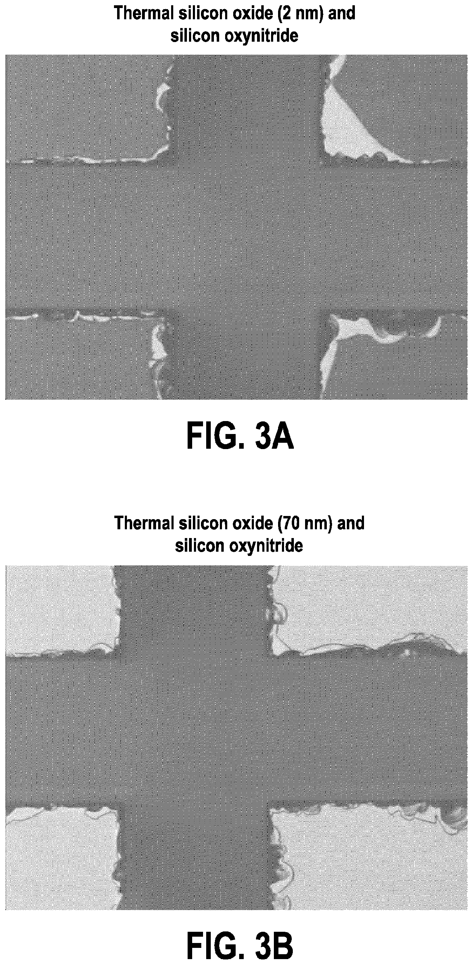

**FIGS. 3A and 3B** illustrate electrical devices for which different extents of delamination have occurred.

These figures corroborate the experimental results presented above. As shown on FIG. 3A, the use of a thin silicon dioxide layer 121 (*i.e*., with a thickness of 2 nm) can lead to delamination when dicing the wafer. In contrast, as shown on FIG. 3B, the use of a sufficiently thick silicon dioxide layer 121 (*i.e*., with a thickness of 70 nm) allows preventing delamination from occurring when dicing the wafer.

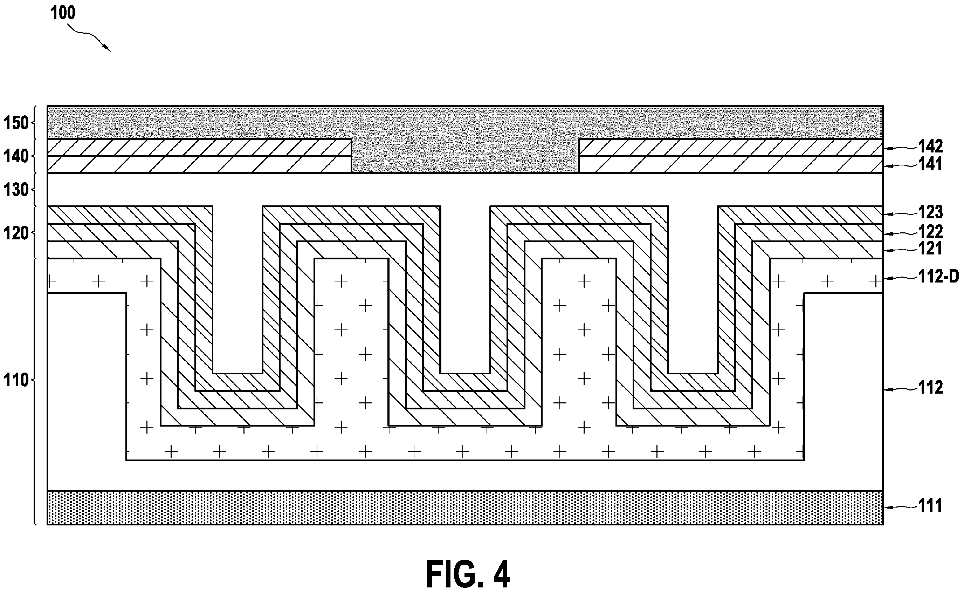

**FIG. 4** illustrates a cross-section view of an electrical device according to another embodiment. This embodiment is presented hereinafter to describe additional experimental results obtained by the inventors.

In comparison to the embodiment of FIG. 1, the electrical device 100 further comprises here: an insulating layer 140, and a conductive layer 150.

These additional layers allow forming electrical contacts and/or interconnections with the capacitor (via the conductive layer 150).

The insulating layer 140 (also referred to as the *inter-metal insulating layer)* extends on (*i.e*., in contact with) the top electrode structure 130. As illustrated on FIG. 4, the insulating layer 140 comprises contact holes opening onto the top electrode structure 130.

The insulating layer 140 can be formed by a single dielectric layer, or a stack of multiple dielectric layers 141-142. For instance, it can comprise a first silicon dioxide layer 142 formed using TEOS (by chemical vapor deposition of tetraethylorthosilicate), or a second silicon dioxide layer 142 formed using PECVD (Plasma Enhanced Chemical Vapor Deposition). It can also comprise both silicon dioxide layers 141-142.

The conductive layer 150 (also referred to as the *contact plate)* extends on the insulating layer 140 and fills the contact holes. This layer 150 thereby forms electrical contacts with the top electrode structure 130.

Precisely, the contacts correspond to the regions of the conductive layer 150 filling the contact holes so as to electrically connect the conductive layer 150 with the top electrode structure 130. For example, the conductive layer 150 can be a layer of aluminum (Al) or copper (Cu).

With regards to the electrical device of FIG. 4, the inventors have carried out multiple experiments and have obtained the following results.

**Table 2: Influence of the thickness of the insulating layer 140 on delamination**

| Si substrate | dieletric layer stack in saw-lane | | | | | blade dicing results |
|---|---|---|---|---|---|---|
| | capacitor dielectric structure 120 | | | inter-metal insulating layer 140 | | |
| | SiO₂ layer 121 (Thermal) | Si₃N₄ layer 122 (LPCVD) | SiO₂ layer 123 (TEOS) | SiO₂ layer 141 (TEOS) | SiO₂ layer 142 (PECVD) | |
| N+ As doped | 20 nm | 51.5 nm | 15 nm | | | OK: No delamination |
| | 20 nm | 51.5 nm | 15 nm | | 500 nm | NOK: Strong delamination |
| 1-5 mohm.cm | 100 nm | 100 nm | 15 nm | | | OK: No delamination |
| | 100 nm | 100 nm | 15 nm | 400 nm | | NOK: Strong delamination |

Table 2 outlines the delamination observed for different configurations of the dielectric structure 120 and insulating layer 140.

The inventors have observed that the thickness of the insulating layer 140 has a significant impact on delamination. Additional dielectric layers in the electrical device 100 have to be carefully chosen to ensure adherence to the substrate 112.

These experimental results have shown that the presence of an inter-metal insulating layer 140 results in delamination when dicing the wafer. Therefore, no inter-metal oxide should be present in the saw lane above the capacitor dielectric structure 120 to prevent delamination.

Based on the above experimental results, particular embodiments of the present invention propose that the electrical device 100 includes no inter-metal oxide layer 140 in the saw lanes. This allows preventing delamination when dicing the wafer.

Lastly, Table 3 provides a detailed summary of the inventor's experimental results.

**Table 3: Detailed summary of the inventors' results on delamination**

| Si substrate | dieletric layer stack in saw-lane | | | | | blade dicing results |
|---|---|---|---|---|---|---|
| | capacitor dielectric structure 120 | | | inter-metal insulating layer 140 | | |
| | SiO₂ layer 121 (Thermal) | Si₃N₄ layer 122 (LPCVD) | SiO₂ layer 123 (TEOS) | SiO₂ layer 141 (TEOS) | SiO₂ layer 142 (PECVD) | |
| N+ As doped | 2 nm | 55.5 nm + oxidation | | | | NOK: Strong delamination |
| | 2 nm | 55.5 nm + oxidation | | 400 nm | 1500 nm | NOK: Strong delamination |
| | 70 nm | 55.5 nm + oxidation | | | | ∼OK: Acceptable delamination |
| 1-5 mohm.cm | 20 nm | 51.5 nm | 15 nm | | | OK: No delamination |
| | 20 nm | 51.5 nm | 15 nm | | 500 nm | NOK: Strong delamination |
| | 100 nm | 100 nm | 15 nm | | | OK: No delamination |
| | 100 nm | 100 nm | 15 nm | 400 nm | | NOK: Strong delamination |
| P+ B doped | 2 nm | 55.5 nm + oxidation | | | | NOK: Strong delamination |
| 25-38 mohm.cm | 70 nm | 55.5 nm + oxidation | | | | ∼OK: Acceptable delamination |

The proposed electrical device 100 may comprise any of the configurations of the dielectric structure 120 and of the insulating layer 140 included in the table above and for which delamination results were positive (OK, or ~OK).

However, the present invention is not limited to the particular thickness values indicated above. Within the scope of the present invention, the thickness values of the various layers 121-123 of the dielectric structure 120 indicated above can be adapted by considering intervals of 10 nm (or even 20 nm). This still allows preventing delamination.

Other embodiments of the present invention could also be envisaged in which the dielectric structure 120 comprises additional layers beyond those mentioned above.

**Additional Variants:** Although the present invention has been described above with reference to certain specific embodiments, it will be understood that the invention is not limited by the particularities of these specific embodiments. Numerous variations, modifications, and developments may be made in the above-described embodiments within the scope of the claims.

In particular, the present invention has been described in reference to a capacitor with a 3D capacitive structure. However, other embodiments of the present invention can also be used for planar capacitors.

It is to be understood that references in this text to directions and locations, such as "*top*" and "*bottom*", "*front*" and "*rear*", merely refer to the directions that apply when architectures and components are oriented as illustrated in the accompanying drawings.

## Claims

1. An electrical device (100) comprising a capacitor including:
- a bottom electrode structure (110) comprising a silicon substrate (112), the silicon substrate (112) comprising:
∘ a region (112-D) doped with phosphorus and extending up to all lateral edges of the electrical device (100),
- a dielectric structure (120) extending on the bottom electrode structure (110), the dielectric structure (120) comprising at least:
∘ a dielectric layer (121) comprising thermal silicon dioxide on the silicon substrate (112), a thickness of this layer (121) being equal to or greater than 20 nm,
- a top electrode structure (130) extending on the dielectric structure (120).

2. The electrical device (100) according to claim 1, wherein the dielectric structure (120) comprises a stack of layers including:
- the dielectric layer (121) comprising thermal silicon dioxide, the thickness of this layer (121) being comprised between 65 and 75 nm, and
- a dielectric layer (122) comprising silicon oxynitride, a thickness of this layer (122) being comprised between 50.5 and 60.5 nm.

3. The electrical device (100) according to claim 1, wherein the dielectric structure (120) comprises a stack of layers including:
- the dielectric layer (121) comprising thermal silicon dioxide, the thickness of this layer (121) being comprised between 20 and 30 nm,
- a dielectric layer (122) comprising silicon nitride, a thickness of this layer (122) being comprised between 46.5 and 56.5 nm, and
- another dielectric layer (123) comprising silicon dioxide, a thickness of this layer (123) being comprised between 10 and 20 nm.

4. The electrical device (100) according to claim 1, wherein the dielectric structure (120) comprises a stack of layers including:
- the dielectric layer (121) comprising thermal silicon dioxide, the thickness of this layer (121) being comprised between 95 and 105 nm,
- a dielectric layer (122) comprising silicon nitride, a thickness of this layer (122) being comprised between 95 and 105 nm, and
- another dielectric layer (123) comprising silicon dioxide, a thickness of this layer (123) being comprised between 10 and 20 nm.

5. The electrical device (100) according to any of claims 1 to 4, wherein the substrate (112) is a silicon substrate doped with boron or with arsenic, comprising the region (112-D) doped with phosphorus.

6. The electrical device (100) according to any of claims 1 to 5, wherein the electrical device (100) comprises no further dielectric layer extending on or above the top electrode structure (130), at least along the lateral edges of the electrical device (100).

7. The electrical device (100) according to any of claims 1 to 6, wherein:
- the silicon substrate (112) comprises reliefs,
- the dielectric structure (120) extends conformally on the reliefs of the silicon substrate (112), and
- the top electrode structure (130) extends conformally on the dielectric structure (120).

8. A method for manufacturing an electrical device (100) comprising a capacitor, said method comprising:
- providing a bottom electrode structure (110) comprising a silicon substrate (112), the silicon substrate (112) having a surface and comprising:
∘ a region (112-D) doped with phosphorus and extending over substantially all of the surface of the silicon substrate (112),
- forming a dielectric structure (120) extending on the bottom electrode structure (110), this step comprising:
∘ forming a dielectric layer (121) comprising silicon dioxide by thermal oxidation of the silicon substrate (112), a thickness of this layer (121) being equal to or greater than 20 nm,
- forming a top electrode structure (130) extending on the dielectric structure (120).

9. The method according to claim 8, wherein the step of providing the bottom electrode structure (110) comprises:
- full-sheet doping of the silicon substrate (112) with phosphorus.

10. The method according to claim 8 or 9, comprising:
- dicing to delimit the electrical device (100), wherein the dicing is performed through the region (112-D) doped with phosphorus.

11. The method according to any of claims 8 to 10, wherein:
- the thickness of the dielectric layer (121) comprising thermal silicon dioxide is comprised between 65 and 75 nm, and
- the step of forming the dielectric structure (120) further comprises:
∘ forming a dielectric layer (122) comprising silicon nitride and oxidizing this layer, a thickness of this layer (122) being comprised between 50.5 and 60.5 nm.

12. The method according to any of claims 8 to 10, wherein:
- the thickness of the dielectric layer (121) comprising thermal silicon dioxide is comprised between 20 and 30 nm, and
- the step of forming the dielectric structure (120) further comprises:
∘ forming a dielectric layer (122) comprising silicon nitride, a thickness of this layer (122) being comprised between 46.5 and 56.5 nm, and
∘ forming another dielectric layer (123) comprising silicon dioxide, a thickness of this layer (123) being comprised between 10 and 20 nm.

13. The method according to any of claims 8 to 10, wherein:
- the thickness of the dielectric layer (121) comprising thermal silicon dioxide is comprised between 95 and 105 nm, and
- the step of forming the dielectric structure (120) further comprises:
∘ forming a dielectric layer (122) comprising silicon nitride, a thickness of this layer (122) being comprised between 95 and 105 nm, and
∘ forming another dielectric layer (123) comprising silicon dioxide, a thickness of this layer (123) being comprised between 10 and 20 nm.
